(19) Europäisches Patentamt
European Patent Office
Office européen des brevets

(11) **EP 3 683 967 A1**

(12) **EUROPEAN PATENT APPLICATION**
published in accordance with Art. 153(4) EPC

(43) Date of publication:
**22.07.2020 Bulletin 2020/30**

(51) Int Cl.:
***H03L 7/08*** *(2006.01)*     ***H03L 7/091*** *(2006.01)*

(21) Application number: **17929219.8**

(22) Date of filing: **17.10.2017**

(86) International application number:
**PCT/JP2017/037492**

(87) International publication number:
**WO 2019/077673 (25.04.2019 Gazette 2019/17)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Mitsubishi Electric Corporation Chiyoda-ku Tokyo 100-8310 (JP)**

(72) Inventors:
• **WADA, Osamu**
  **Tokyo 100-8310 (JP)**
• **MIZUTANI, Hiroyuki**
  **Tokyo 100-8310 (JP)**
• **TAJIMA, Kenichi**
  **Tokyo 100-8310 (JP)**

(74) Representative: **Pfenning, Meinig & Partner mbB Patent- und Rechtsanwälte Joachimsthaler Straße 10-12 10719 Berlin (DE)**

(54) **SIGNAL SOURCE**

(57) Conventional signal sources each have a disadvantage that the noise in a control voltage of a VCO increases, thereby deteriorating the phase noise of an output signal of the signal source.

A signal source of the present invention includes: a reference signal source for outputting a reference signal; a phase frequency comparator for detecting a phase difference between the reference signal and an oscillation signal and outputting a signal corresponding to the phase difference; a filter for filtering the signal output by the phase frequency comparator; an oscillator for outputting the oscillation signal depending on the signal filtered by the filter; and an S/H circuit for receiving a clock signal for controlling a phase of the oscillation signal by controlling sampling operation and holding operation, sampling at least one of the oscillation signal and the reference signal in synchronization with the clock signal, and outputting at least one of the sampled reference signal and the sampled oscillation signal to the phase frequency comparator, the S/H circuit disposed between the oscillator and the phase frequency comparator or between the reference signal source and the phase frequency comparator.

FIG. 1

## Description

### TECHNICAL FIELD

The present invention relates to a signal source capable of desirably varying the phase of an output signal.

### BACKGROUND ART

Signal sources are circuits capable of each generating a desired signal waveform or a signal of a desired frequency. A signal source includes, for example, a component such as a phase locked loop (PLL) circuit or a direct digital synthesizer (DDS).

A PLL circuit includes a voltage controlled oscillator (VCO), a frequency divider, a loop filter (LF), a phase frequency comparator (phase frequency detector (PFD)), and a reference signal source. The PLL circuit compares the frequency and the phase of a frequency-divided output signal of a VCO and those of an output signal of a reference signal, and stabilizes the oscillation frequency of the VCO by feeding back a current or a voltage corresponding to the error in the frequency and the phase to the VCO through an LF.

The phase noise of an output signal of the PLL circuit is determined from the phase noise of each of the VCO, the frequency divider, the LF, the PFD, and the reference signal source. Among these, the phase noise of the PFD deteriorates by the frequency division number of the frequency divider in the feedback path of the PLL circuit and thereby appears in the output signal of the PLL circuit. In order for the PLL circuit to generate a signal having low phase noise suitable for a wireless communication device or the like, it is necessary to reduce the frequency division number of the frequency divider in the feedback path without varying the frequency of the output signal.

As a conventional signal source for generating a signal having low phase noise and a desirable phase using a PLL circuit, for example, Patent Literature 1 describes a configuration in which a VCO in a subsampling PLL outputs four phases, and switches are used for switching charge pump circuits provided to the respective four phases. Since the output signals of the VCO are frequency-converted by subsampling, and no frequency divider is used in the signal source, signals with low phase noise can be output. The VCO simultaneously outputs four signals having the same frequency but different phases, performs subsampling and compares the phase with that of a reference signal for each of the signals, and outputs the comparison results to the VCO via the charge pump circuits and an LF. By switching the charge pump circuits, a signal to be phase-synchronized with the reference signal among the four output signals of the VCO can be switched, and thus the phases of the output signals can be varied.

### CITATION LIST

#### PATENT LITERATURE

JP 2012-60581 A

### SUMMARY OF INVENTION

#### TECHNICAL PROBLEM

However, since the four charge pumps are switched by the switches in the signal source in Patent Literature 1, switching noise at the time of switching is superimposed on the four charge pumps. This results in a disadvantage that the noise in a control voltage of the VCO increases, thereby deteriorating the phase noise of output signals of the signal source.

The present invention has been made in order to solve the disadvantage as described above, and an object of the present invention is to provide a signal source capable of suppressing deterioration of the phase noise even when the phase of an output signal is varied.

#### SOLUTION TO PROBLEM

A signal source of the present invention includes: a reference signal source to output a reference signal; a phase frequency comparator to detect a phase difference between the reference signal and an oscillation signal and output a signal corresponding to the phase difference; a filter to filter the signal output by the phase frequency comparator; an oscillator to output the oscillation signal depending on the signal filtered by the filter; and an S/H circuit to receive a clock signal for controlling a phase of the oscillation signal by controlling sampling operation and holding operation, sample at least one of the oscillation signal and the reference signal in synchronization with the clock signal, and output at least one of the sampled reference signal and the sampled oscillation signal to the phase frequency comparator, the S/H circuit disposed between the oscillator and the phase frequency comparator or between the reference signal source and the phase frequency comparator.

#### ADVANTAGEOUS EFFECTS OF INVENTION

According to the present invention, it is possible to provide a signal source in which deterioration in terms of phase noise is suppressed since there is no need to switch between circuits having high sensitivity to noise.

### BRIEF DESCRIPTION OF DRAWINGS

FIG. 1 is a configuration diagram illustrating a configuration example of a signal source according to a first embodiment of the present invention.

FIG. 2 includes graphs illustrating temporal waveforms of a clock signal and an output signal of an S/H circuit 5 in the signal source according to the first embodiment of the present invention.

FIG. 3 is a graph illustrating an output signal of a filter 6 when the duty ratio is 50% in the signal source according to the first embodiment of the present invention.

FIG. 4 is a graph illustrating an output signal of the filter 6 when the duty ratio is 45% in the signal source according to the first embodiment of the present invention.

FIG. 5 includes graphs illustrating temporal waveforms of clock signals when the frequency of the clock signal in the signal source according to the first embodiment of the present invention is varied.

FIG. 6 is a configuration diagram illustrating a configuration example in a case where a preset circuit is used in the signal source according to the first embodiment of the present invention.

FIG. 7 is a configuration diagram illustrating another configuration example in a case where a preset circuit is used in the signal source according to the first embodiment of the present invention.

FIG. 8 is a configuration diagram illustrating a configuration example of a signal source according to a second embodiment of the present invention.

FIG. 9 is a configuration diagram illustrating a configuration example of a signal source according to a third embodiment of the present invention.

DESCRIPTION OF EMBODIMENTS

First Embodiment

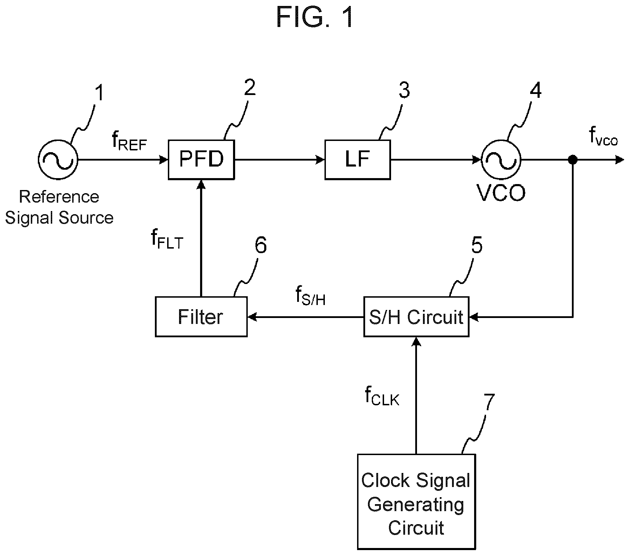

FIG. 1 is a configuration diagram illustrating a configuration example of a signal source according to a first embodiment of the present invention.

The signal source includes a reference signal source 1, a PFD 2, an LF 3, a VCO 4, a sample and hold circuit (S/H circuit) 5, a filter 6, and a clock signal generating circuit 7. In FIG. 1, $f_{REF}$ denotes the frequency of a reference signal output from the reference signal source 1, $f_{VCO}$ denotes the frequency of a signal output from VCO 4, $f_{CLK}$ denotes the frequency of a clock signal output from the clock signal generating circuit 7, and $f_{S/H}$ denotes the frequency of a signal output from the S/H circuit 5, and $f_{FLT}$ denotes the frequency of a signal output from the filter 6.

The reference signal source 1 outputs a reference signal of the signal source. The reference signal source 1 oscillates at $f_{REF}$ and outputs the reference signal to the PFD 2. An output terminal of the reference signal source 1 is coupled to an input terminal of the PFD 2. For example, a crystal oscillator, a rubidium oscillator, a cesium oscillator, a DDS, or the like is used for the reference signal source 1. Note that an oscillator of any configuration may be used as the reference signal source 1 as long as the oscillator can output an accurate frequency.

The PFD 2 is a phase frequency comparator for comparing the frequency and the phase of the reference signal output from the reference signal source 1 and those of a signal output from the filter 6, and outputting a signal corresponding to the difference in the frequency and the phase to the LF 3. The reference signal inputting terminal of the PFD 2 is coupled to the output terminal of the reference signal source 1, and a comparison signal inputting terminal of the PFD 2 is coupled to an output terminal of the filter 6. The output terminal of the PFD 2 is coupled to an input terminal of the LF 3. For example, a logic circuit using exclusive OR, a mixer, or the like is used for the PFD 2. In a case where a logic circuit using exclusive OR is used for the PFD 2, an output signal of the PFD 2 has a pulse width corresponding to the difference in the frequency and the phase between the two signals input thereto, whereas in a case where a mixer is used for the PFD 2, an output signal of the PFD 2 is an analog voltage signal corresponding to the difference in the frequency and the phase between the two signals input thereto.

The LF 3 is a filter that smooths the signal corresponding to the difference in the frequency and the phase that is output from the PFD 2, and outputs the smoothed signal as a control voltage of the VCO 4 to the VCO 4. The input terminal of the LF 3 is coupled to the output terminal of the PFD 2, and an output terminal of the LF 3 is coupled to an input terminal of the VCO 4. For example, a low pass filter (LPF) including a capacitor, a resistor, or the like is used for the LF 3. A filter incorporating an operational amplifier may be used depending on required gain.

The VCO 4 is an oscillator for controlling the oscillation frequency by using a control voltage and outputting an oscillation signal corresponding to the control voltage. The input terminal of the VCO 4 is coupled to the output terminal of the LF 3, and an output terminal of the VCO 4 is coupled to a radio frequency (RF) terminal of the S/H circuit 5. For example, an oscillator that variates the oscillation frequency by using a variable capacitance diode, a voltage-controlled crystal oscillator, or the like is used for the VCO 4. A variable capacitance diode varies the capacitance depending on a voltage applied thereto. As a result, the resonance frequency of a resonance circuit including the variable capacitance diode varies, thereby varying the oscillation frequency. An oscillator of any configuration may be used for the VCO 4 as long as the oscillation frequency of the oscillator varies depending on a voltage.

The S/H circuit 5 is a sample and hold (also referred to as a track and hold) circuit that synchronizes with the clock signal output from the clock signal generating circuit 7, subsamples (undersamples) the oscillation signal output from the VCO 4, and outputs the subsampled signal to the filter 6. An RF terminal of the S/H circuit 5 is coupled to the output terminal of the VCO 4, a clock terminal of the S/H circuit 5 is coupled to the output terminal of the clock signal generating circuit 7, and an output terminal of the S/H circuit 5 is coupled to the input terminal of the filter 6. For the S/H circuit 5, for example, a circuit is used that includes a switch for switching between the open and short states of a line for an RF signal (oscillation signal of the VCO 4) input thereto and a capacitor for storing a charge when the line is open for the RF signal input thereto. The S/H circuit 5 may have any configuration as long as an input RF signal can be subsampled and the subsampled signal can be output. Here, the subsampled signal refers to a signal generated by the subsampling operation.

The filter 6 has a predetermined pass band and passes a signal within the pass band out of the signal output from the S/H circuit 5 to suppress signals in frequency bands other than the pass band. The filter 6 suppresses signals that exist outside the passband and unwanted waves among the signal output from the S/H circuit 5, and outputs the obtained signal to the PFD 2. An input terminal of the filter 6 is coupled to the output terminal of the S/H circuit 5, and the output terminal of the filter 6 is coupled to the comparison signal inputting terminal of the PFD 2. For example, the filter 6 is implemented using a chip inductor, a chip capacitor, or the like. A resonator may be included depending on a frequency band to be passed or a required amount of suppression, such as a resonator using another microstrip line or a coaxial resonator.

The clock signal generating circuit 7 generates a clock signal for the S/H circuit 5. The clock signal generating circuit 7 generates a clock signal for controlling the phase of the output signal of the VCO 4 by controlling the sampling operation and the holding operation of the S/H circuit 5 and outputs the clock signal to the S/H circuit 5. The output terminal of the clock signal generating circuit 7 is coupled to the clock terminal of the S/H circuit 5. The clock signal indicates timing for holding an input RF signal in the S/H circuit 5, and may be any signal as long as the timing can be indicated.

For example, a sine wave having an initial phase of 0 and a constant frequency can be used as the clock signal. The clock signal may be a sine wave, a rectangular wave, or a triangular wave and may have a single frequency component or multiple frequency components, and the initial phase may or may not be 0. Furthermore, the duty ratio may or may not be constant. For the clock signal generating circuit 7 for generating the clock signal, for example, a DDS or a PLL circuit can be used. As the clock signal generating circuit 7, a circuit having any configuration may be used as long as the circuit is capable of generating a desirable signal waveform.

Note that, although not illustrated in FIG. 1, the clock signal generating circuit 7 may generate the clock signal in synchronization with a reference signal input externally. The reference signal may be input externally, or the output signal of the reference signal source 1 or the VCO 4 may be used. Alternatively, a signal obtained by frequency-converting the output signal of the reference signal source 1 or the VCO 4 may be used. Further alternatively, a clock signal may be generated by a control signal input externally.

The clock signal generating circuit 7 may include an arithmetic circuit for calculating the waveform of the clock signal from a desired phase of the output signal of the VCO 4. As the operation circuit, for example, a field programmable gate array (FPGA) capable of performing digital signal processing at a high speed can be used. A memory may be further included for storing a correspondence table between the phase of the output signal of the VCO 4 and the waveform of the clock signal. In this case, the clock signal generating circuit 7 reads the waveform of the clock signal from the memory in accordance with a signal indicating the phase of the output signal of the VCO 4 input externally, and generates the clock signal.

Although not illustrated in FIG. 1, the clock signal generating circuit 7 may generate the waveform of the clock signal on the basis of a detection result in a phase detection circuit that detects the phase of the output signal of the VCO 4 or the phase of the output signal of the filter 6. As the phase detection circuit, for example, a frequency divider or a mixer that frequency-converts a high frequency signal to a low-frequency signal, an analog to digital converter (ADC) that convert an analog signal to a digital signal, an FPGA capable of performing arithmetic processing of digital signals at a high speed, and the like can be used in combination.

Note that, in addition to the S/H circuit 5, for example, a separate frequency converting circuit may be disposed which is capable of varying the frequency of the input signal or the output signal of the S/H circuit 5, in the feedback path of the PLL circuit from the output terminal of the VCO 4 to the comparison signal inputting terminal of the PFD 2. For the frequency converting circuit, for example a frequency divider, a mixer, or the like can be used, or a combination thereof or a plurality of frequency dividers or mixers may be used.

Alternatively, a separate frequency converting circuit capable of varying the frequency of the reference signal may be disposed in the path from the output terminal of the reference signal source 1 to the reference signal inputting terminal of the PFD 2. For the frequency converting circuit, for example a frequency divider, a multiplier, or the like can be used, or a combination thereof or a plurality of frequency dividers or multipliers may be used.

Next, the operation according to the first embodiment of the present invention will be described.

First, a case where the phase of an output signal of the signal source is varied by varying the "duty ratio" of the clock signal will be described. Here, an LPF is used as the filter 6 and a rectangular wave is used as the clock signal in FIG. 1 in order to simplify the explanation. The explanation is given on the case where $f_{REF}$ = 10 MHz,

$f_{VCO}$ = 1010 MHz, and $f_{CLK}$ = 200 MHz hold.

The reference signal source 1 outputs a reference signal having a frequency of 10 MHz to the PFD 2.

The PFD 2 compares the frequency and the phase of the reference signal output from the reference signal source 1 and those of a signal output from the filter 6, and inputs a signal indicating the difference in the frequency and the phase to the VCO 4 via the LF 3.

The VCO 4 oscillates at a frequency of 1010 MHz corresponding to the control voltage output by the LF 3, and outputs the oscillation signal to the S/H circuit 5.

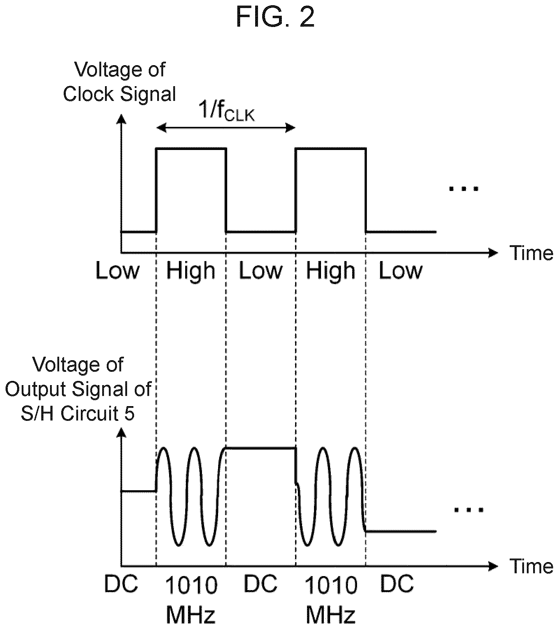

FIG. 2 includes graphs illustrating temporal waveforms of a clock signal and an output signal of the S/H circuit 5 in the signal source according to the first embodiment of the present invention. The horizontal axis in the upper graph represents time, and the vertical axis represents the voltage of the clock signal. The horizontal axis in the lower graph represents time, and the vertical axis represents the voltage of an output signal of the S/H circuit 5. The clock signal is a rectangular wave having a frequency of 200 MHz, and repeats a high state in which the voltage is high and a low state in which the voltage is low. The S/H circuit 5 performs sampling operation while the clock signal is in a high state, and outputs the signal having a frequency of 1010 MHz input thereto to the filter 6. The S/H circuit 5 further holds the voltage of an input signal as of the moment when the clock signal transits from the high state to a low state and continues to hold the voltage while the clock signal is in the low state. While holding the voltage of the output signal of the S/H circuit 5, the S/H circuit 5 outputs a signal having a frequency of a direct current (DC) to the filter 6.

The S/H circuit 5 performs subsampling of the output signal of the VCO 4 with the clock signal, and thus a folding component of the output signal of the VCO 4 is generated for each Nyquist zone. The frequencies of the output signal of the S/H circuit 5 and these folding components can be expressed by the following Expressions (1) and (2).

$$f_{VCO} + n \cdot f_{CLK} \cdots (1)$$

$$|f_{VCO} - n \cdot f_{CLK}| \cdots (2)$$

Where n is a positive integer. As can be understood from Expressions (1) and (2), the output signal of the S/H circuit 5 includes a large number of spurious signals. However, in order to simplify the explanation, it is assumed that the output signal of the S/H circuit 5 is a signal having a frequency represented by n = 5 in Expression (2) and that no other signals nor spurious signals exist. In this case, $f_{S/H}$ = 10 MHz.

The filter 6 passes a signal having a frequency of 10 MHz among the signal output from the S/H circuit 5 and outputs the passed signal to the PFD 2. Note that the filter 6 is included in order to prevent malfunction due to input of a large number of spurious signals to the PFD 2 or a failure due to input of high power spurious signals to the PFD 2. Although it is assumed in this example that spurious signals are not generated from the S/H circuit 5, in a case where spurious signals are generated from the S/H circuit 5, the pass band of the filter or an implementing method of the filter is determined so that the spurious signals can be sufficiently suppressed. The filter 6 in that case may be a band pass filter (BPF) or a high pass filter (HPF). Alternatively, in a case where no malfunction nor a failure occurs in the PFD 2 such as that the frequencies of spurious signals generated in the S/H circuit 5 are other than the frequency at which the PFD 2 can operate or that the power of spurious signals is low, the filter 6 may be a through circuit.

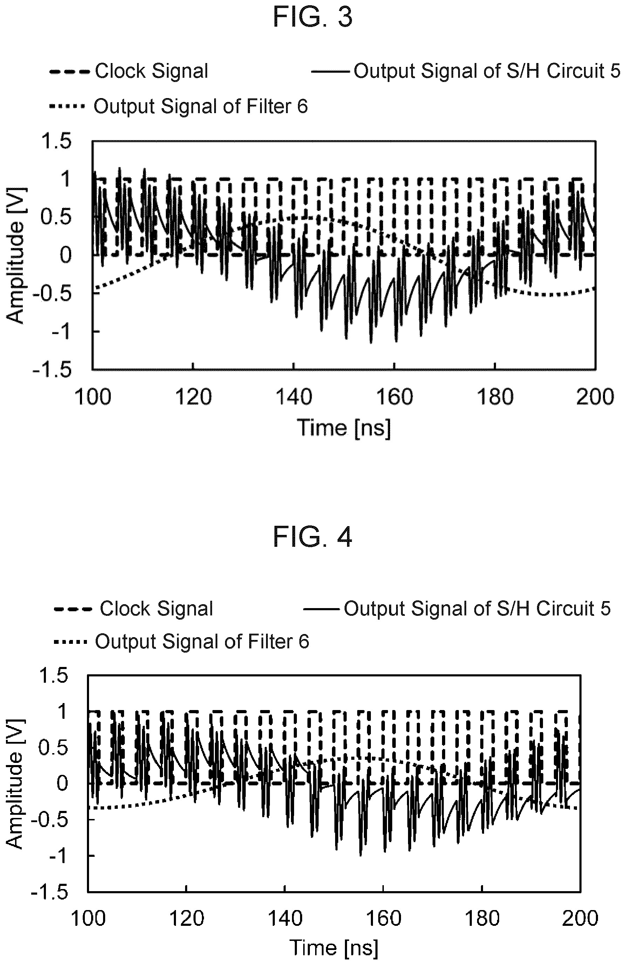

FIG. 3 is a graph illustrating an output signal of the filter 6 when the duty ratio is 50% in the signal source according to the first embodiment of the present invention. The horizontal axis represents time, and the vertical axis represents the voltage. A broken line indicates the clock signal, a solid line indicates the output signal of the S/H circuit 5, and a dotted line indicates the output signal of the filter 6. Here, the duty ratio of 50% indicates that the ratio of duration between the high state and the low state of the clock signal is 50:50. The S/H circuit 5 repeats the sampling operation and the holding operation in accordance with the clock signal. The filter 6 smooths the signal output from the S/H circuit 5 and outputs the smoothed signal to the PFD 2.

FIG. 4 is a graph illustrating an output signal of the filter 6 when the duty ratio is 45% in the signal source according to the first embodiment of the present invention. The horizontal axis represents time, and the vertical axis represents the voltage. A broken line indicates the clock signal, a solid line indicates the output signal of the S/H circuit 5, and a dotted line indicates the output signal of the filter 6. Here, the duty ratio of 45% indicates that the ratio of duration between the high state and the low state of the clock signal is 45:55. Since the duty ratio of the clock signal is different in FIG. 4 from that in FIG. 3, timing for the S/H circuit 5 to perform the sampling operation and the holding operation is different. As a result, the frequencies of the output signal of the S/H circuit 5 and the output signal of the filter 6 do not vary, whereas the phases of those signals vary. Note that, although not illustrated in FIG. 4, the output signal of filter 6 in FIG. 4 is delayed by time $t_{d1}$ as compared to the output signal of filter 6 in FIG. 3.

The PFD 2 compares the phase with that of the signal output from the reference signal source 1, and outputs a signal corresponding to the phase difference to the LF 3. Once the phases of the reference signal and the output signal of filter 6 match in the PFD 2 (when the output signal of the VCO 4 is in phase synchronization with the reference signal), the relationship among $f_{REF}$, $f_{CLK}$, and $f_{VCO}$ can be expressed by the following Equations (3) and (4) from Expressions (1) and (2).

$$f_{REF} = f_{vco} + n \cdot f_{CLK} \cdots (3)$$

$$f_{REF} = |f_{vco} - n \cdot f_{CLK}| \cdots (4)$$

In this example, since the phases of the signals that filter 6 outputs to the PFD 2 are different between the cases where the duty ratio of the clock signal is 50% and is 45%. Therefore, the phases of signals that the PFD 2 outputs are also different between the cases where the duty ratio is 50% and is 45%. That is, the control voltage that the PFD 2 outputs to the VCO 4 via the LF 3 also differs between the cases. For example, when the duty ratio is varied from 50% to 45%, since the output signal of the filter 6 is delayed by time $t_{d1}$ after the variation, the PFD 2 operates to advance the output signal of the filter 6. However, since the frequency of the output signal of the filter 6 stays unchanged after the variation of the duty ratio, the PFD 2 operates so as to vary the phase of the output signal of the filter 6.

Once the phases of the reference signal and the output signal of filter 6 match in the PFD 2 (when the output signal of the VCO 4 is in phase synchronization with the reference signal), the relationship among $f_{REF}$, $f_{CLK}$, and $f_{VCO}$ can be expressed by the following Equation (5) from Equation (4) and the above-mentioned assumption that n = 5 holds.

$$f_{REF} = f_{vco} - 5 \cdot f_{CLK} \cdots (5)$$

Here, let $\theta_1$ be a phase difference of output signals that are generated in the VCO 4 between the cases where the duty ratio is 50% and is 45%, and $\theta_1$ can be expressed by the following Equation (6).

$$\theta_1 = 2\pi \cdot f_{FLT} \cdot t_{d1} \cdots (6)$$

As described above, the phase of the output signal of the signal source varies by varying the duty ratio of the clock signal. Note that although the case where the duty ratios are 50% and 45% has been described here, the duty ratio may be other values, or may vary with time.

Next, the case where the phase of the output signal of the signal source is varied by varying the "phase" of the clock signal will be described. Here, an LPF is used as the filter 6 and a rectangular wave is used as the clock signal in FIG. 1 in order to simplify the explanation.

Let $\theta_{S/H}$ be the phase of the output signal of the S/H circuit 5, then $\theta_{S/H}$ can be expressed by the following Equation (7).

$$\theta_{S/H} = |\theta_{IN} - n \cdot \theta_{CLK}| \cdots (7)$$

Note that $\theta_{CLK}$ denotes the phase of the clock signal, $\theta_{IN}$ denotes the phase of the input signal of the S/H circuit 5 (output signal of the VCO), and $\theta_{CLK}$ and $\theta_{IN}$ are both real numbers. It is understood from Equation (7) that, when the phase of the clock signal varies, the phase of the output signal of the S/H circuit 5 also varies. As a result, the phase of the output signal of the filter 6 also varies, and the PFD 2 operates so as to match the phase of the output signal of the filter 6 with the phase of the reference signal. Therefore, like in the case where the duty ratio is varied, the phase of the output signal of the signal source varies when the phase of the clock signal is varied.

Note that when the "phase" of the clock signal is varied, the amount of variation may be constant or vary with time.

Next, a case where the phase of an output signal of the signal source is varied by varying the "phase ($f_{CLK}$)" of the clock signal will be described.

First, a case where the phase of an output signal of the signal source is varied by switching clock signals having the same phase but different frequencies will be described. Here, an LPF is used as the filter 6, and a rectangular wave is used as the clock signal in FIG. 1 in order to simplify the explanation. The case where $f_{REF}$ = $f_{S/H}$ = $f_{FLT}$ = 10 MHz, and $f_{VCO}$ = 1010 MHz hold, and $f_{CLK}$ is varied from 200 MHz to 510 MHz will be described.

In a case where phase synchronization is established when $f_{CLK}$ = 200 MHz, n = 5 is obtained from Equation (4). At this point, the phase of the output signal of the S/H circuit 5 obtained from Equation (7) is $\theta_{IN}$ - $5\theta_{CLK}$. Meanwhile, in a case where phase synchronization is established after varying $f_{CLK}$ to 510 MHz, n = 2 is obtained from Equation (4). At this point, the phase of the output signal of the S/H circuit 5 obtained from Equation (7) is $\theta_{IN}$ - $2\theta_{CLK}$. As a result, in a case where $\theta_{CLK}$ is constant regardless of the frequency, varying the $f_{CLK}$ varies the phase of the output signal of the S/H circuit 5, and the PFD 2 operate to match the phase of the output signal of the filter 6 with the phase of the reference signal. Therefore, like in the case where the duty ratio is varied, the phase of the output signal of the signal source varies when the phase of the clock signal is varied.

Although the case where $f_{CLK}$ is switched from 200 MHz to 510 MHz has been described in the above description, any frequency may be used as long as Equations (3) and (4) are satisfied and n varies as $f_{CLK}$ varies. These conditions are, in other words, to vary the frequency of the clock signal without varying the phase of the clock signal and to vary the phase of the output signal of the S/H circuit 5 without varying the frequency of the output signal of the S/H circuit 5. In the above example, even when the frequency of the clock signal is varied, the frequency of the output signal of the S/H circuit 5 is in a first Nyquist zone and the frequency remains the same.

Furthermore, a case will be described in which the phase of the output signal of the signal source is varied by switching clock signals having the same average frequency but different variation patterns of frequency (exemplary signal patterns). Here, an LPF is used as the filter 6, and a rectangular wave is used as the clock signal in FIG. 1 in order to simplify the explanation. Furthermore, a case where $f_{REF} = f_{S/H} = f_{FLT} = 10$ MHz holds, two frequencies of 200 MHz and 202 MHz are switched for $f_{CLK}$, and $f_{VCO}$ is expressed by Equation (4) will be described.

From Equation (4), $f_{VCO} = 1010$ MHz is obtained when $f_{CLK} = 200$ MHz, and $f_{VCO} = 1020$ MHz is obtained when $f_{CLK} = 202$ MHz, and thus $f_{VCO}$ varies depending on $f_{CLK}$. Therefore, when $f_{CLK}$ is switched between the two frequencies of 200 MHz and 202 MHz, $f_{VCO}$ is switched between the two frequencies of 1010 MHz and 1020 MHz, and thus the average of $f_{CLK}$ is 201 MHz and the average of $f_{VCO}$ is 1015 MHz.

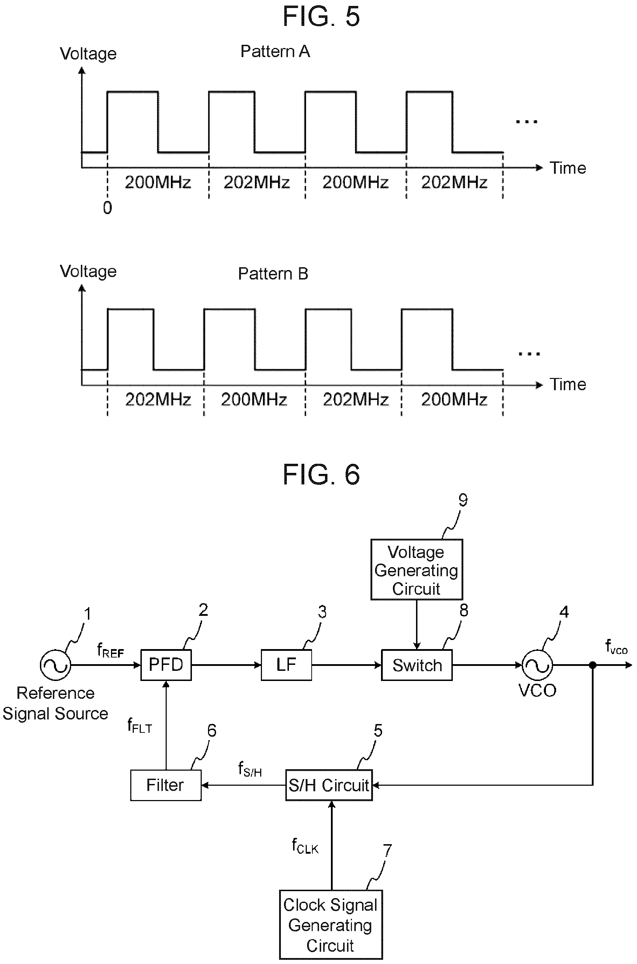

FIG. 5 includes graphs illustrating temporal waveforms of clock signals when the frequency of the clock signal in the signal source according to the first embodiment of the present invention is varied. In both the upper and lower graphs, the horizontal axis represents time, and the vertical axis represents the voltage. The upper graph illustrates the case where the frequency is varied in the order of 200 MHz, 202 MHz, 200 MHz, ... from time point 0 (hereinafter referred to as pattern A), and the lower graph illustrates the case where the frequency is varied in the order of 202 MHz, 200 MHz, 202 MHz, ... from time point 0 (hereinafter referred to as pattern B). When the clock signals of patterns A and B are used, the average of $f_{CLK}$ is 201 MHz and the average of $f_{VCO}$ is 1015 MHz in both of the cases.

However, since the variation patterns of the clock frequency are different between the patterns A and B, the timing at which the S/H circuit 5 performs the sampling operation and the holding operation is different. As a result, the phase of the output signal of the S/H circuit 5 varies. Therefore, like in the cases described above in which the duty ratio or the phase is changed, the phase of the output signal of the VCO 4 varies by varying the frequency of the clock signal.

The clock signal is switched between two frequencies in the above description; however, three or more frequencies may be switched. In order to switch the frequency of the clock signal, it is only required to switch to a clock signal having the same average frequency but a different signal component. Here, the average frequency of the clock signal means an average value of frequencies of the clock signal within a certain desirable period of time or a predetermined period of time. Having a different signal component means that at least one of the phase, the duty ratio, and the frequency is different. Note that there may be or may not be periodicity when a signal component is varied. For example, in a case where no periodicity is imparted, $\Delta\Sigma$ modulation can be used for switching the frequency. Furthermore, the clock frequency may be varied continuously in terms of time like a chirp signal, or a temporally discontinuous clock signal and a temporally continuous clock signal may be used in combination.

Regarding how to vary the clock signal, as described in the case of switching to a clock signal having the same phase but a different frequency, the frequency of the clock signal may be varied only once when the phase of the output signal of the VCO 4 is varied. Furthermore, as described in the case of switching to a clock signal having the same average frequency but a different variation pattern of frequency, the frequency of the clock signal may be continuously varied as long as the average frequency remains the same.

As described above, according to the first embodiment, the phase of the output signal of the signal source can be varied by varying the temporal waveform of the clock signal input to the S/H circuit 5. As a result, the phase of the output signal of the signal source is varied without switching circuits having high sensitivity to noise, and thus it is possible to implement a signal source in which deterioration of phase noise is reduced.

Note that, although the output signal of the S/H circuit 5 satisfies n = 5 or 2 in Expression (2) in the description of the first embodiment, the output signal may be expressed by Expression (1), and n may be another positive integer. Moreover, as long as Equations (3) and (4) are satisfied, the magnitude relationship among $f_{REF}$, $f_{CLK}$, and $f_{VCO}$ may be any relationship.

Furthermore, although the cases of varying only the duty ratio, only the phase, and only the frequency of the clock signal have been described in the first embodiment, a similar effect to that of the configuration illustrated in FIG. 1 is achieved even when the clock signal is generated by varying more than one of the duty ratio, the phase, and the frequency. The combination of the duty ratio, the phase, and the frequency may be any combination as long as the average frequency of the clock signal remains the same when the temporal waveform of the clock signal is varied. Furthermore, although the clock signal for the S/H circuit 5 is generated by using the clock signal generating circuit 7, a similar effect to that of the configuration illustrated in FIG. 1 is achieved even when a clock signal generated outside the signal source is input to the S/H circuit 5.

Note that, for example, in a case where the frequency of the output signal of the VCO 4 is switched to a broadband, such as when the value of n in Expressions (1) and (2) varies as the frequency of the output signal of the VCO 4 is switched, there is a possibility that a malfunction occurs that $f_{VCO}$ is phase-synchronized with a frequency other than a desired output frequency. In order to prevent this malfunction, frequency switching may be performed using a preset circuit. The preset circuit can be configured using, for example, a switch and a voltage generating circuit.

FIG. 6 is a configuration diagram illustrating a configuration example in a case where a preset circuit is used in the signal source according to the first embodiment of the present invention. In this example, a switch 8 and a voltage generating circuit 9 are included in the preset circuit. In FIG. 6, the switch 8 is coupled between the output terminal of the LF 3 and the input terminal of the VCO 4, and the voltage generating circuit 9 is coupled to the switch 8. The switch 8 switches so as to output either a signal output from the LF 3 or a voltage signal having a frequency of DC output from the voltage generating circuit 9 to the VCO 4. When the frequency is switched, first, the signal output from the voltage generating circuit 9 is output to the VCO 4 to bring $f_{VCO}$ sufficiently close to a desired frequency after switching. Here, "to bring $f_{VCO}$ sufficiently close to" means to bring $f_{VCO}$ sufficiently close so that a difference between the desired frequency after switching and the frequency of the output signal of the VCO 4 is lower than or equal to the natural frequency of the PLL circuit. Then, the switch 8 is switched to output the output signal of the LF 3 to the VCO 4 to allow $f_{VCO}$ to converge to the desired frequency after switching by using the feedback path of the PLL circuit including the S/H circuit 5.

Note that, for example, a digital-to-analog converter (DAC), a DDS, or a PLL circuit can be used for the voltage generating circuit 9. In a case where the voltage generating circuit 9 is a PLL circuit, for example, a possible configuration is that the voltage generating circuit 9 divides the output signal of the VCO 4 into two signals, uses one of the divided two signals as the output of the signal source, and inputs the other one of the divided two signals to a PFD (PFD different from the PFD 2) after frequency-converting the other signal via a frequency divider or a mixer, and the PFD compares the frequency and the phase of the frequency-converted signal with the frequency and the phase of the reference signal, and outputs the comparison result to the switch 8 via an LF (LF different from the LF 3). The voltage generating circuit 9 may adopt any configuration as long as the configuration enables generation of a voltage having a frequency of a DC corresponding to the oscillation frequency of the VCO 4.

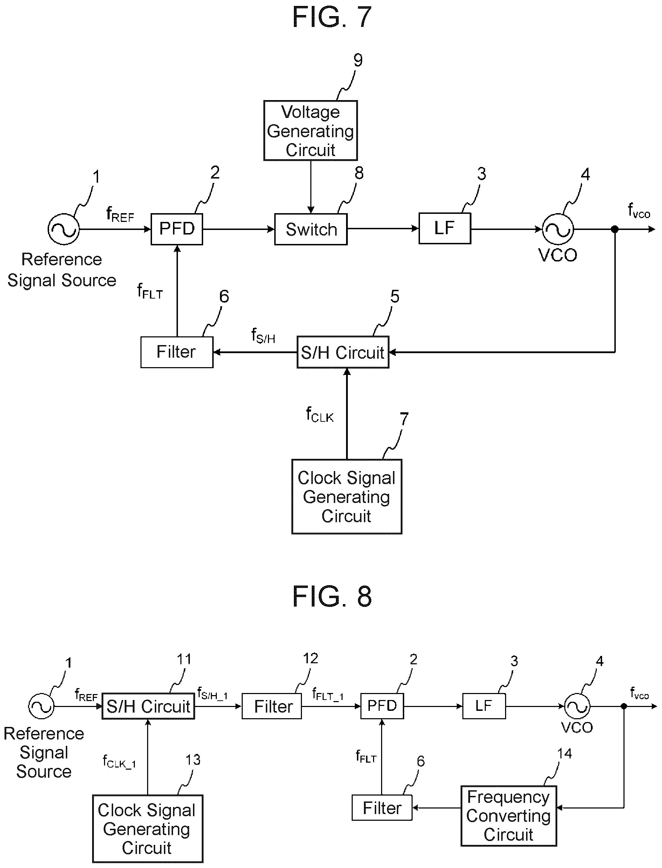

FIG. 7 is a configuration diagram illustrating another configuration example in a case where a preset circuit is used in the signal source according to the first embodiment of the present invention. A switch 8 of the preset circuit may be coupled between the output terminal of the PFD 2 and the input terminal of the LF 3.

Second Embodiment

In the first embodiment, the configuration in which the output signal of the VCO 4 is subsampled has been described. A second embodiment illustrates a configuration in which a reference signal output from a reference signal source 1 is subsampled. In a general PLL circuit, the frequency of an output signal of a reference signal source is lower than the frequency of an output signal of a VCO, and thus subsampling an output signal of the reference signal source 1 can reduce the frequency of the input signal of an S/H circuit and relax the restriction on the input frequency required for the S/H circuit.

FIG. 8 is a configuration diagram illustrating a configuration example of a signal source according to a second embodiment of the present invention.

In FIG. 8, the same symbols as those in FIG. 1 represent the same or corresponding parts and thus description thereof is omitted. Symbol $f_{S/H\_1}$ denotes the frequency of an output signal of an S/H circuit 11, $f_{FLT\_1}$ denotes the frequency of an output signal of a filter 12, and $f_{CLK\_1}$ denotes the frequency of an output signal of the clock signal generating circuit 13. In the second embodiment, the S/H circuit 5 in the first embodiment is replaced with a frequency converting circuit 14, and the S/H circuit 11, the filter 12, and the clock signal generating circuit 13 are arranged in the path between a reference signal source 1 and a PFD 2. The S/H circuit 11 subsamples the output signal of the reference signal source 1 and outputs the subsampled output signal to the PFD 2 via the filter 12.

The S/H circuit 11 is a sample and hold circuit for subsampling an RF signal (reference signal output from the reference signal source 1) input thereto in synchronization with a clock signal input thereto and outputting the subsampled signal to the filter 12. An RF terminal of the S/H circuit 11 is coupled to an output terminal of the reference signal source 1, a clock terminal of the S/H circuit 11 is coupled to an output terminal of the clock signal generating circuit 13, and an output terminal of the S/H circuit 11 is coupled to an input terminal of the filter 12. For the S/H circuit 11, for example, a circuit is used that includes a switch for switching between the open and short states of a line for an RF signal input thereto and a capacitor storing a charge when the line for the RF signal input thereto is open. The S/H circuit 11 may have any configuration as long as an input RF signal can be subsampled and the subsampled signal can be output.

The filter 12 has a predetermined pass band and passes a signal within the pass band out of the signal input thereto to suppress signals in frequency bands other than the pass band. The filter 12 suppresses signals that exist outside the passband and unwanted waves among the signal output from the S/H circuit 11, and outputs the obtained signal to the PFD 2. The input terminal of the filter 12 is coupled to the output terminal of the S/H circuit 11, and an output terminal of the filter 12 is coupled to a reference signal inputting terminal of the PFD 2. For example, the filter 12 is implemented using a chip inductor, a chip capacitor, or the like. It goes without saying that a resonator may be included depending on a frequency band to be passed or a required amount of suppression, such as a resonator using another microstrip line or a coaxial resonator.

The clock signal generating circuit 13 generates a clock signal for the S/H circuit 11. The clock signal generating circuit 13 generates a clock signal for controlling the phase of the output signal of the VCO 4 and outputs the clock signal to the S/H circuit 11. The output terminal of the clock signal generating circuit 13 is coupled to the clock terminal of the S/H circuit 11. For the clock signal generating circuit 13, for example, a DDS or a PLL circuit can be used. As the clock signal generating circuit 13, a circuit having any configuration may be used as long as the circuit is capable of generating a desirable signal waveform.

The frequency converting circuit 14 converts the frequency of the signal output from the VCO 4 and outputs the frequency-converted output signal of the VCO 4 to the PFD 2. For the frequency converting circuit 14, for example, a frequency divider, a multiplier, a mixer, a DDS, an S/H circuit, or the like is used. The frequency converting circuit 14 may employ any configuration as long as the configuration enables conversion of the frequency of an input signal and output of the converted signal. Moreover, a frequency divider or a multiplier may be used in combination, or a plurality of frequency dividers or multipliers may be used. Note that frequency control data is input from the outside when a DDS is used for the frequency converting circuit 14, a local oscillator (LO) wave is input from the outside when a mixer is used, and a clock signal is input from the outside when an S/H circuit is used. The frequency of the output signal of the frequency converting circuit 14 may be the same as $f_{VCO}$, and in this case, the frequency converting circuit 14 is to be a through circuit. An input terminal of the frequency converting circuit 14 is coupled to an output terminal of the VCO 4, and an output terminal of the frequency converting circuit 14 is coupled to an input terminal of a filter 6.

Note that a separate frequency converting circuit capable of varying the frequency may be disposed in addition to the S/H circuit 11 in the path from the output terminal of the reference signal source 1 to the reference signal inputting terminal of the PFD 2. For the frequency converting circuit, for example a frequency divider, a mixer, or the like can be used, or a combination thereof or a plurality of frequency dividers or mixers may be used.

Next, the operation of the signal source according to the second embodiment of the present invention will be described. First, a case where the phase of an output signal of the signal source is varied by varying the "duty ratio" of the clock signal will be described. In this example, for simplicity of explanation, a through circuit is used as the frequency converting circuit 14, an LPF is used as the filter 6, a BPF is used as the filter 12, and a rectangular wave is used as the clock signal. The explanation is given on the case where $f_{REF}$ = 10 MHz, $f_{VCO}$ = $f_{FLT}$ = $f_{FLT\_1}$ = 1010 MHz, and $f_{CLK}$ = 200 MHz hold.

The reference signal source 1 outputs a reference signal having a frequency of 10 MHz to the S/H circuit 11. The S/H circuit 11 performs sampling operation and holding operation depending on the high state and the low state of the clock signal output from the clock signal generating circuit 13, and subsamples the reference signal. At this point, $f_{S/H\_1}$ can be expressed by Expressions in which $f_{VCO}$ is replaced with $f_{REF}$ and $f_{CLK}$ is replaced with $f_{CLK\_1}$ in Expressions (1) and (2). Like in the description in the first embodiment, the output signal of the S/H circuit 11 includes a large number of spurious signals. Hereinafter, it is assumed that the output signal of the S/H circuit 11 is that obtained in the case where $f_{VCO}$ is replaced with $f_{REF}$ and $f_{CLK}$ is replaced with $f_{CLK\_1}$ in Expression (1), and n = 5, and that other signals nor spurious signals do not exist. In this case, $f_{S/H\_1}$ = 1010 MHz can be obtained.

The filter 12 passes a signal having a frequency of 1010 MHz among the signal output from the S/H circuit 11 and outputs the passed signal to the PFD 2. Here, the filter 12 is a BPF that passes a signal having a frequency of 1010 MHz. Note that the filter 12 is included in order to prevent malfunction due to input of a large number of spurious signals to the PFD 2 or a failure due to input of high power spurious signals to the PFD 2. Although it is assumed that spurious signals are not generated from the S/H circuit 11, in a case where spurious signals are generated from the S/H circuit 11, the pass band of the filter or an implementing method of the filter is determined so that the spurious signals can be sufficiently suppressed. In this case, the filter 12 may be an LPF or an HPF. Alternatively, in a case where no malfunction nor a failure occurs in the PFD 2 such as that the frequencies of spurious signals generated in the S/H circuit 11 are other than the frequency at which the PFD 2 can operate or that the power of spurious signals is low, the filter 12 may be a through circuit.

The clock signal generating circuit 13 generates and outputs a clock signal to the S/H circuit 11. For example, when the clock signal generating circuit 13 generates clock signals having different duty ratios, the timing of sampling operation and holding operation differs in the S/H circuit 11 depending on the duty ratios. As a result, the output signals of the filter 12, the PFD 2, and the LF 3 vary like as described in the first embodiment. Thus, the phase of the output signal of the VCO 4 varies by varying the duty ratio.

Although the output signal of the S/H circuit 11 satisfies n = 5 in Expression (1) in the above description, the output signal may be expressed by Expression (2), and n may be another positive integer. As long as Equations (3) and (4) are satisfied, the magnitude relationship among $f_{REF}$, $f_{CLK\_1}$, and $f_{VCO}$ may be any relationship.

Like in the description in the first embodiment, the phase of the output signal of the VCO 4 also varies when the phase or the frequency is varied other than the duty ratio of the clock signal. Detailed description will be omitted in order to avoid redundancy with the first embodiment.

As described above, according to the second embodiment, even when the clock signal for the S/H circuit 11 for subsampling the output signal of the reference signal source 1 is varied, a similar effect to that of the first embodiment is achieved. In addition, in a case where the frequency of the output signal of the reference signal source 1 is low, the restriction on the input frequency required for the S/H circuit can be relaxed by lowering the input frequency of the S/H circuit.

Note that, although the case of varying only the duty ratio of the clock signal has been described in the second embodiment, a similar effect to that of the configuration illustrated in FIG. 8 is achieved even when the clock signal is generated by varying more than one of the duty ratio, the phase, and the frequency. The combination of the duty ratio, the phase, and the frequency may be any combination as long as the average frequency of the clock signal remains the same when the temporal waveform of the clock signal is varied. Furthermore, although the clock signal for the S/H circuit 11 is generated by using the clock signal generating circuit 13, a similar effect to that of the configuration illustrated in FIG. 8 is achieved even when a clock signal generated outside the signal source is input to the S/H circuit 11.

Third Embodiment

In the first embodiment, the output signal of the VCO 4 is subsampled. In a third embodiment, by subsampling each of the output signals of the VCO 4 and the reference signal source 1, the resolution of the phase (phase resolution) that can be set when the phase of an output signal of the signal source is set is improved.

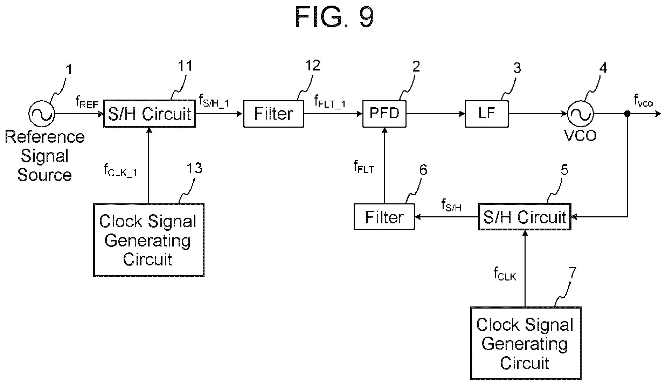

FIG. 9 is a configuration diagram illustrating a configuration example of a signal source according to a third embodiment of the present invention.

In FIG. 9, the same symbols as those in FIG. 1 or 8 represent the same or corresponding parts and thus description thereof is omitted. In the third embodiment, an S/H circuit 11, a filter 12, and a clock signal generating circuit 13 are arranged in the path between the reference signal source 1 and the PFD 2 in the first embodiment, and the S/H circuit 11 subsamples the output signal of the reference signal source 1 and outputs the subsampled output signal to the PFD 2 via the filter 12.

Next, the operation of the signal source according to the third embodiment of the present invention will be described. Since it has been described that the phase of the output signal of the VCO 4 varies by varying the clock signals for the S/H circuit 5 and the S/H circuit 11 in the first embodiment and the second embodiment, the description thereof will be omitted. Here, the improvement in the phase resolution of the output signal of the VCO 4 will be described with reference to the configuration diagram illustrated in FIG. 9. Note that, to simplify the description, it is assumed that the clock signals of the S/H circuit 5 and the S/H circuit 11 are each varied separately, that the output signal of the filter 6 is delayed by time $t_{d2}$ as compared to that before the variation, and that an output signal of the filter 12 is delayed by time $t_{d3}$ as compared to that before the variation.

In this case, let a phase difference of output signals of the VCO 4 before and after variation of the clock signal be $\theta_2$, then $\theta_2$ can be expressed by the following Equation (8).

$$\theta_2 = \left| 2\pi \cdot f_{FLT} \cdot t_{d2} - 2\pi \cdot f_{FLT\_1} \cdot t_{d3} \right| \cdots (8)$$

The phase difference $\theta_2$ of the output signal of the VCO 4 expressed by Equation (8) has a larger number of variables as compared to the phase difference $\theta_1$ of the output signal of the VCO 4 expressed by Equation (4) in the first embodiment, and thus the resolution of the phase setting of the output signal is improved.

As described above, according to the third embodiment, even when the clock signals for the S/H circuit 5 for subsampling the output signal of the VCO 4 and for the S/H circuit 11 for subsampling the output signal of the reference signal source 1 are varied, a similar effect to that of the first embodiment can be achieved. In addition, since the number of variables for determining the phase of the output signal of the VCO 4 increases, the resolution of phase setting is improved.

Note that, in the above description, the clock signals for the S/H circuit 5 and the S/H circuit 11 are different from each other; however, the same clock signals may be used. In this case, the same clock signals may be output from the same clock signal generating circuit, may be output from different respective clock signal generating circuits, or may be generated outside the signal source. Moreover, like in the first and second embodiments, a similar effect to that of the configuration illustrated in FIG. 9 is achieved in the case where one or more of the duty ratio, the phase, and the frequency of the clock signal are varied. The combination of the duty ratio, the phase, and the frequency may be any combination as long as the average frequency of the clock signal remains the same when the temporal waveform of the clock signal is varied.

REFERENCE SIGNS LIST

1: reference signal source, 2: PFD, 3: LF, 4: VCO, 5, 11: S/H circuit, 6, 12: filter, 7 ,13: clock signal generating circuit, 8: switch, 9: voltage generating circuit, 14: frequency converting circuit

**Claims**

1. A signal source comprising:

   a reference signal source to output a reference signal;
   a phase frequency comparator to detect a phase difference between the reference signal and an oscillation signal and output a signal corresponding to the phase difference;
   a filter to smooth the signal output by the phase frequency comparator;
   an oscillator to output the oscillation signal depending on the signal smoothed by the filter; and

an S/H circuit to receive a clock signal for controlling a phase of the oscillation signal by controlling sampling operation and holding operation, sample at least one of the oscillation signal and the reference signal in synchronization with the clock signal, and output at least one of the sampled reference signal and the sampled oscillation signal to the phase frequency comparator, the S/H circuit disposed between the oscillator and the phase frequency comparator or between the reference signal source and the phase frequency comparator.

2. The signal source according to claim 1, further comprising a clock signal generating circuit to control the clock signal so as to vary a frequency of the clock signal without varying the phase of the clock signal when the phase of the oscillation signal output from the oscillator is varied.

3. The signal source according to claim 2, wherein a frequency of the output signal of the S/H circuit is in a first Nyquist zone.

4. The signal source according to claim 1, further comprising a clock signal generating circuit to generate a plurality of the clock signals having a same average frequency but different signal components.

5. The signal source according to claim 4, wherein the clock signal generating circuit controls the phase of the oscillation signal, by switching signal patterns of the clock signals having the same average frequency but different signal components.

6. The signal source according to claim 5, wherein the signal patterns switched by the clock signal generating circuit are different in at least one of duty ratio, phase, and frequency.

7. The signal source according to claim 1, further comprising:

   a voltage generating circuit to output a signal for controlling the oscillator; and
   a switch to switch between the signal output from the phase frequency comparator and the signal output from the voltage generating circuit, the switch disposed between the phase frequency comparator and the oscillator.

8. The signal source according to claim 7, wherein the switch switches between the signal output from the phase frequency comparator and the signal output from the voltage generating circuit when the oscillator varies a frequency of the output signal of the oscillator.

# FIG. 1

# FIG. 2

Voltage of
Clock Signal

$1/f_{CLK}$

Low · High · Low · High · Low · · ·

Time

Voltage of
Output Signal of
S/H Circuit 5

· · ·

Time

DC · 1010 MHz · DC · 1010 MHz · DC

# FIG. 3

- - - Clock Signal ———— Output Signal of S/H Circuit 5

••••• Output Signal of Filter 6

# FIG. 4

- - - Clock Signal ———— Output Signal of S/H Circuit 5

••••• Output Signal of Filter 6

# FIG. 5

Voltage

Pattern A

| 200MHz | 202MHz | 200MHz | 202MHz |

Time

0

Voltage

Pattern B

| 202MHz | 200MHz | 202MHz | 200MHz |

Time

# FIG. 6

9

Voltage
Generating
Circuit

1

$f_{REF}$

2

PFD

3

LF

8

Switch

4

VCO

$f_{VCO}$

Reference
Signal Source

$f_{FLT}$

6

Filter

$f_{S/H}$

5

S/H Circuit

$f_{CLK}$

7

Clock Signal
Generating
Circuit

# FIG. 7

# FIG. 8

# FIG. 9

**EP 3 683 967 A1**

<table>
<tr><td colspan="2" align="center">INTERNATIONAL SEARCH REPORT</td><td>International application No.<br>PCT/JP2017/037492</td></tr>
</table>

**A. CLASSIFICATION OF SUBJECT MATTER**
Int.Cl. H03L7/08(2006.01)i, H03L7/091(2006.01)i

According to International Patent Classification (IPC) or to both national classification and IPC

**B. FIELDS SEARCHED**

Minimum documentation searched (classification system followed by classification symbols)
Int.Cl. H03L7/08, H03L7/091

Documentation searched other than minimum documentation to the extent that such documents are included in the fields searched
| | |
|---|---|
| Published examined utility model applications of Japan | 1922–1996 |
| Published unexamined utility model applications of Japan | 1971–2017 |
| Registered utility model specifications of Japan | 1996–2017 |
| Published registered utility model applications of Japan | 1994–2017 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | US 2002/0191728 A1 (HAFEZ, A. N. et al.) 19 December 2002, paragraphs [0030]-[0042], fig. 2-4<br>& US 6463112 B1 & CA 2310311 A1 | 1<br>7-8<br>2-6 |
| X<br>Y<br>A | JP 2010-534444 A (TERADYNE, INC.) 04 November 2010, paragraphs [0014]-[0025], fig. 2-4<br>& WO 2009/014535 A1, page 5, line 2 to page 7, line 6, fig. 2-4 & KR 10-2010-0033411 A & CN 101765974 A | 1<br>7-8<br>2-6 |

☒ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>20.12.2017 | Date of mailing of the international search report<br>09.01.2018 |
|---|---|
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

| International application No. |
| --- |
| PCT/JP2017/037492 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2001-077690 A (MATSUSHITA ELECTRIC INDUSTRIAL CO., LTD.) 23 March 2001, paragraphs [0048]-[0061], fig. 2 (Family: none) | 7-8 |
| A | JP 2004-343724 A (MATSUSHITA ELECTRIC INDUSTRIAL CO., LTD.) 02 December 2004 & US 2004/0207475 A1 & CN 1540636 A & TW 200506879 A | 2-6 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012060581 A